# EUROPEAN PATENT SPECIFICATION

(11) **EP 3 076 755 B1**
(45) Date of publication and mention of the grant of the patent: **30.08.2023**
(21) Application number: 14866026.9
(22) Date of filing: 07.03.2014
(51) Int. Cl.: H10K 50/813, H10K 50/814

(54) **LIGHT EMITTING DEVICE**
LICHTEMITTIERENDE VORRICHTUNG
DISPOSITIF ÉLECTROLUMINESCENT

(30) Priority: 28.11.2013 WO PCT/JP2013/082107
(43) Date of publication of application: 05.10.2016
(73) Proprietor: Pioneer Corporation, Tokyo 113-0021 (JP)
(72) Inventor: AOKI, Toshihiko, Yonezawa-shi Yamagata 992-1128 (JP); MURAKATA, Masaki, Yonezawa-shi Yamagata 992-1128 (JP); SATO, Yosuke, Yonezawa-shi Yamagata 992-1128 (JP)
(74) Representative: Vossius & Partner Patentanwälte Rechtsanwälte mbB
(86) International application number: PCT/JP2014/056015
(87) International publication number: WO 2015/079718

(56) References cited:
- WO-A1-2013/161005
- WO-A1-2013/161005
- WO-A1-2014/069144
- JP-A- 2004 063 407
- JP-A- 2005 293 875
- JP-A- 2008 186 618
- JP-A- 2008 257 951
- JP-A- 2009 157 288
- JP-A- 2009 157 288
- JP-A- 2010 176 962
- JP-A- 2010 176 962

## Description

### TECHNICAL FIELD

The present invention relates to a light emitting device.

### BACKGROUND ART

In recent years, development of light emitting elements including an Organic Electroluminescence (EL) element, a Light Emitting Diode (LED), or the like has continued to advance. When the light emitting element is made to emit light, it is necessary to supply power to the light emitting element. On the other hand, in a case where a plurality of light emitting elements are provided in parallel, a current may converge on a specific light emitting element such as a case where short-circuit of an anode and a cathode occurs in a certain light emitting element. In this case, there is a concern of the light emitting element deteriorating.

On the other hand, JP 2004-296154 A discloses connecting interconnects, for connecting a plurality of light emitting elements in parallel, to each of the light emitting elements by fuse type interconnects. It is disclosed that thereby, an overcurrent can be prevented from flowing to the light emitting elements.

Document WO 2013/161005 A1 discloses an organic EL panel containing a substrate, a light-emitting unit disposed within an effective light-emitting region on the substrate, a pair of current supply terminals disposed on the outside of the effective light-emitting region on the substrate, and serial lateral resistance units which are disposed on the outside of the effective light-emitting region on the substrate and which are connected to the light-emitting unit in series relative to the pair of current supply terminals.

In document JP 2010-176962 A a mother panel with a plurality of light-emitting display portions having a plurality of light-emitting pixels are disclosed. The light-emitting pixels are formed by holding a functional layer at least including an organic light-emitting layer between positive electrodes and negative electrodes. A positive electrode conduction line electrically connects between the positive electrodes of the first and second light-emitting display portions and a power source, and a negative electrode conduction line electrically connects between the negative electrodes of the first and second light-emitting display portions.

Document JP 2009-157288 A describes a substrate including a driver IC; a wiring portion; a first conduction line; a second conduction line; and an insulating layer. The driver IC is provided corresponding to each organic electroluminescent device to be electrically connected with first and second electrodes. The insulating layer is formed between the wiring portion and second conduction line and the second electrode.

JP 2008-186618 A discloses a device provided with a first substrate with translucency, a first electrode formed on a surface of the first substrate, an element part intercalated between the first electrode and a second electrode opposed to the former and equipped with an emitting function layer including an organic layer. A second substrate is positioned in opposition to the first substrate" so as to pinch the element part and is equipped with a first and a second electrode terminal for external connection. A sealing part is formed between the first and the second substrates so as to surround the element part.

### SUMMARY OF THE INVENTION

In a technique disclosed in JP 2004-296154 A, in a case where a current converges on a specific light emitting element, the fuse type interconnect becomes fused, and thus it is not possible to make the light emitting element emit light again. For this reason, the inventor has examined connecting a resistor element to each of a plurality of light emitting elements. However, when the resistor element is connected to the light emitting element, manufacturing costs of the light emitting device are increased.

The problem to be solved by the invention is to prevent the convergence of a current on a specific light emitting element while suppressing manufacturing costs of a light emitting element.

The invention is defined in the independent claim 1. In the following, the parts of the description and drawings referring to embodiments which are not covered by the claims are not presented as embodiments of the invention but as background art or examples useful for understanding the invention.

### BRIEF DESCRIPTION OF THE DRAWINGS

The above-described objects, other objects, features and advantages will become further apparent from the preferred embodiments described below, and the accompanying drawings as follows.
FIG. 1 is a diagram in which an organic layer and an insulating layer are removed from FIG. 2.
FIG. 2 is a diagram in which a second electrode is removed from FIG. 3.
FIG. 3 is a diagram in which a sealing member is removed from FIG. 4.
FIG. 4 is a plan view of a light emitting device.
FIG. 5 is an enlarged view of a region surrounded by a dotted line α in FIG. 1.
FIG. 6 is an equivalent circuit diagram of the light emitting device.
FIG. 7 is a cross-sectional view taken along line A-A in FIG. 1.
FIG. 8 is a cross-sectional view taken along line B-B in FIG. 1.
FIG. 9 is a plan view of a light emitting device according to a first modification example.
FIG. 10 is an equivalent circuit diagram of the light emitting device illustrated in FIG. 9.
FIG. 11 is a plan view of a light emitting device according to a second modification example.
FIG. 12 is a plan view of a light emitting device according to a third modification example.
FIG. 13 is a plan view illustrating a configuration of a light emitting device according to a fourth modification example.
FIG. 14 is a plan view illustrating a configuration of a light emitting device according to a fifth modification example.
FIG. 15 is a plan view illustrating a configuration of a light emitting device according to a sixth modification example.
FIG. 16 is a plan view illustrating a configuration of a light emitting device according to a seventh modification example.
FIG. 17 illustrates a configuration of a light emitting device according to an eighth modification example.
FIG. 18 is a plan view illustrating a configuration of a light emitting device according to a ninth modification example.
FIG. 19 is a plan view illustrating a configuration of a light emitting device according to a tenth modification example.
FIG. 20 is a plan view illustrating a configuration of a light emitting device according to an eleventh modification example.
FIG. 21 is a cross-sectional view taken along line C-C in FIG. 20.

### DESCRIPTION OF EMBODIMENTS

Hereinafter, embodiments of the invention will be described with reference to the accompanying drawings. In all the drawings, like reference numerals denote like components, and a description thereof will not be repeated.

### Embodiment

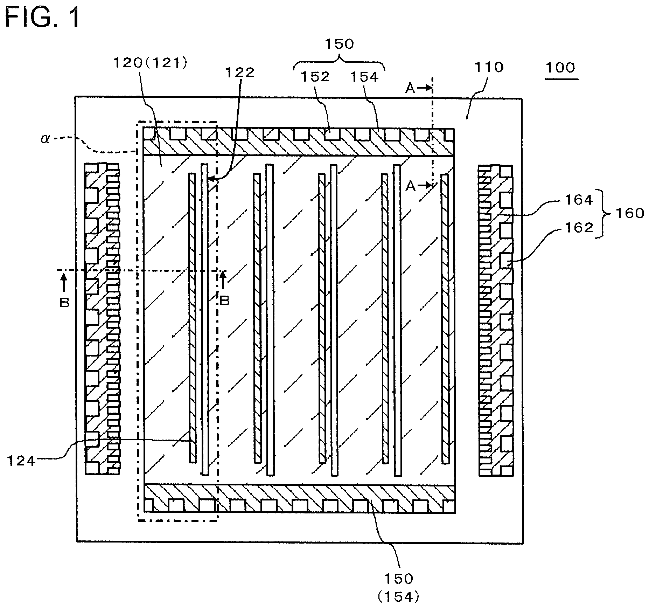

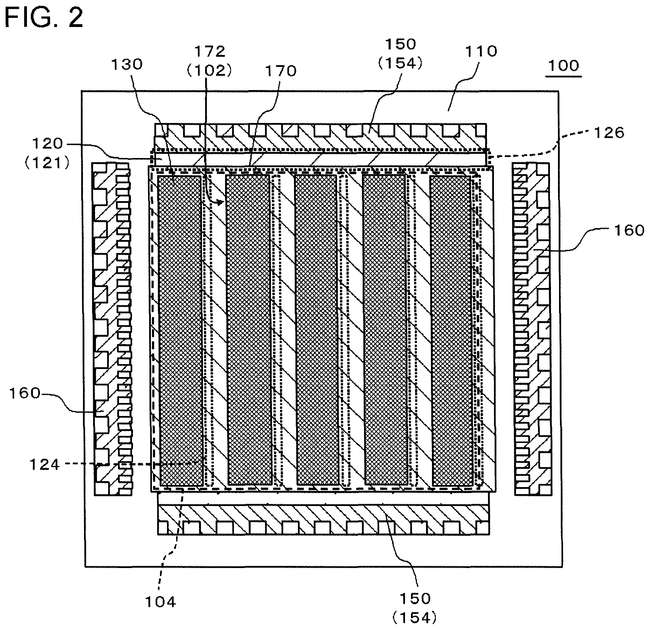

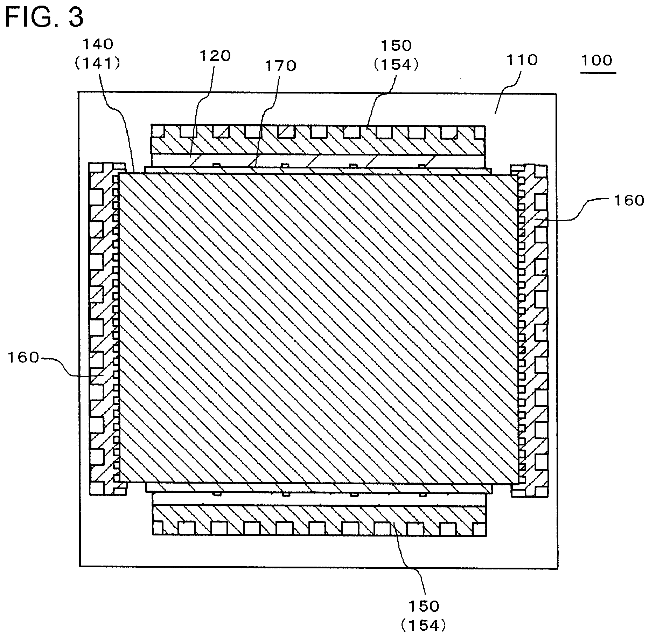

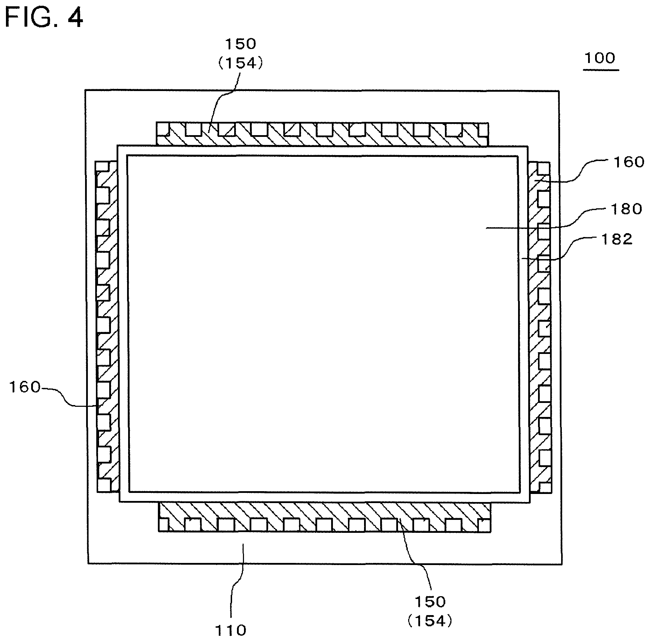

FIGS. 1 to 4 are plan views of a light emitting device 100. FIG. 3 is a diagram in which a sealing member 180 is removed from FIG. 4, FIG. 2 is a diagram in which a second electrode 140 is removed from FIG. 3, and FIG. 1 is a diagram in which an organic layer 130 and an insulating layer 170 are removed from FIG. 2.

The light emitting device 100 has a polygonal shape such as a rectangular shape, and includes a plurality of light emitting elements 102 (illustrated in FIG. 2), a first light-emitting-side terminal 150, and a second light-emitting-side terminal 160. The light emitting element 102 is, for example, an organic EL element, but may be an LED element. A light emitting portion 104 is formed by the plurality of light emitting elements 102. Hereinafter, a description will be given on the assumption that the light emitting element 102 is an organic EL element.

The first light-emitting-side terminal 150 and the second light-emitting-side terminal 160 are provided in order to supply power to the light emitting elements 102. For this reason, a connection member (for example, a metal interconnect) for supplying power to the light emitting device 100 is connected to the first light-emitting-side terminal 150 and the second light-emitting-side terminal 160. The first light-emitting-side terminal 150 extends in a first direction (horizontal direction in the drawing), and the second light-emitting-side terminal 160 extends in a second direction (for example, the vertical direction in the drawing) which intersects the first direction.

The light emitting element 102 is configured such that a first electrode 120 (a portion of a first conductive film 121), an organic layer 130, and a second electrode 140 (a portion of a second conductive film 141) are laminated on a substrate 110.

In the example illustrated in the drawing, the light emitting element 102 is configured such that the first electrode 120, the organic layer 130, and the second electrode 140 are laminated on the substrate 110 in this order. However, the first electrode 120 and the second electrode 140 may be reversed.

The substrate 110 is a transparent substrate such as a glass substrate or a resin substrate. The substrate 110 may have flexibility. In this case, the thickness of the substrate 110 is, for example, equal to or greater than 10 um and equal to or less than 1000 µm. Also in this case, the substrate 110 may be formed of either an inorganic material or an organic material. The substrate 110 has a polygonal shape such as a rectangular shape.

The organic layer 130 includes a light emitting layer. The organic layer 130 is configured such that, for example, a hole injection layer, a light emitting layer, and an electron injection layer are laminated in this order. A hole transport layer may be formed between the hole injection layer and the light emitting layer. In addition, an electron transport layer may be formed between the light emitting layer and the electron injection layer. At least one layer in the organic layer 130 is formed by a coating method. Meanwhile, the remaining layers in the organic layer 130 are formed by a vapor deposition method. Meanwhile, the organic layer 130 may be formed of a coating material by an ink jet method, a printing method, or a spraying method.

The first electrode 120 functions as an anode of the light emitting element 102, and the second electrode 140 functions as a cathode of the light emitting element 102. One (first electrode 120 in the example illustrated in the drawing) of the first electrode 120 and the second electrode 140 is a transparent electrode having light transmitting properties. Light emitted from the light emitting element 102 is output to the outside through an electrode (first electrode 120 in the example illustrated in the drawing) which is configured as a transparent electrode out of the first electrode 120 and the second electrode 140. Examples of a material of the transparent electrode include an inorganic material, such as Indium Tin Oxide (ITO) or Indium Zinc Oxide (IZO), and a conductive polymer such as a polythiophene derivative.

In addition, the other one (in the example illustrated in the drawing, the second electrode 140) of the first electrode 120 and the second electrode 140 includes a metal layer formed of a metal selected from a first group constituted by Au, Ag, Pt, Sn, Zn, and In, or an alloy of metals selected from the first group.

More specifically, the first electrode 120 is a region (in more detail, a region in contact with the organic layer 130) of the first conductive film 121 which overlaps the organic layer 130. As illustrated in FIG. 1, the first conductive film 121 is connected to the first light-emitting-side terminal 150. The first conductive film 121 is formed continuously from a region of the substrate 110 which serves as the light emitting portion 104 to the first light-emitting-side terminal 150. In the example illustrated in the drawing, the substrate 110 has a rectangular shape, and the first light-emitting-side terminals 150 are provided along two sides of the substrate 110 which face each other. The first conductive film 121 is formed between the two sides.

A plurality of openings 122 are provided in at least a region of the first conductive film 121 which serves as the first electrode 120. The openings 122 extend between the plurality of light emitting elements 102, and divide the first conductive film 121 into the plurality of first electrodes 120. The first electrode 120 included in any of the light emitting elements 102 is also connected to the first light-emitting-side terminal 150 through another portion of the first conductive film 121. For this reason, even when the openings 122 are formed, the first electrodes 120 of the plurality of light emitting elements 102 are connected to each other, and function as a common electrode (one electrode) . Meanwhile, a portion of the first conductive film 121 which is located in the vicinity of the first light-emitting-side terminal 150 does not need to include the opening 122.

All of the openings 122 in FIG. 1 do not reach one first light-emitting-side terminal 150, and extend to and reach the other first light-emitting-side terminal 150. However, at least some openings 122 may extend to and reach the one first light-emitting-side terminal 150. For example, in order to adjust a resistance value in a high-resistance region 106 to be described later, all of the openings 122 does not need to reach two first light-emitting-side terminals 150.

In addition, as illustrated in FIG. 3, the second electrodes 140 of the plurality of light emitting elements 102 may be connected to each other. In other words, the second electrodes 140 are formed as an electrode common to the plurality of light emitting elements 102. In detail, the second electrode 140 is a region (in more detail, a region in contact with the organic layer 130) of the second conductive film 141 which overlaps the organic layer 130. The second conductive film 141 is formed on the organic layer 130 and the insulating layer 170, and is connected to the second light-emitting-side terminal 160. In the example illustrated in the drawing, the second light-emitting-side terminal 160 is formed along two sides of the substrate 110 which face each other. The second conductive film 141 is formed so as to cover a region between the two second light-emitting-side terminals 160.

For example, the light emitting element 102 is defined as a region in which the organic layer 130 and the first conductive film 121 are in contact with each other and the organic layer 130 and the second conductive film 141 are in contact with each other in a laminated body of the first conductive film 121, the organic layer 130, and the second conductive film 141.

In the example illustrated in FIGS. 1 to 4, the first light-emitting-side terminal 150 and the second light-emitting-side terminal 160 are disposed on the outer side of the light emitting portion 104. In detail, two first light-emitting-side terminals 150 are disposed in the second direction so as to be separated from each other, and two second light-emitting-side terminals 160 are disposed in the first direction so as to be separated from each other. The light emitting portion 104 is located between the two first light-emitting-side terminals 150 and between the two second light-emitting-side terminals 160. In this manner, a voltage is supplied to the first electrode 120 from the two first light-emitting-side terminals 150, and a current or a voltage is supplied to the second electrode 140 from the two second light-emitting-side terminals 160, and thus it is possible to suppress the generation of a distribution in a current or a voltage inside the light emitting portion 104. Thereby, it is possible to suppress the generation of a luminance distribution in the light emitting portion 104.

More specifically, as described above, the light emitting device 100 has a rectangular shape. The first light-emitting-side terminal 150 is formed along each of two sides of the light emitting device 100 which face each other, and the second light-emitting-side terminal 160 is formed along each of the remaining two sides of the light emitting device 100. The plurality of light emitting elements 102 are lined up in a direction (first direction) in which the first light-emitting-side terminal 150 extends. In the example illustrated in the drawing, the light emitting element 102 has an oblong shape and has a short side directed to a direction which is parallel to the first light-emitting-side terminal 150. The length of the first light-emitting-side terminal 150 is larger than the short side of the light emitting element 102.

The first light-emitting-side terminal 150 is configured such that a second layer 154 is laminated on a portion (first layer 152) of the first conductive film 121. In other words, the first light-emitting-side terminal 150, the high-resistance region 106, and the first electrode 120 include one continuous first conductive film 121 (single conductive film) . The first layer 152 is integrated with the first electrode 120. For this reason, it is possible to reduce a resistance value between the first light-emitting-side terminal 150 and the first electrode 120 by reducing a distance therebetween. In addition, it is possible to narrow a non-light emission region which is present at an edge of the light emitting device 100.

Meanwhile, in the present embodiment, the edge of the light emitting device 100 indicates a region ranging from an end face to the inside of the light emitting device 100 (or the substrate 110) to a certain degree. In other words, the edge of the light emitting device 100 refers to an end of the light emitting device 100. The end of the light emitting device 100 is, for example, a region between the light emitting portion 104 (or the insulating layer 170 to be described later) of the light emitting device 100 and the end face of the substrate 110.

The second layer 154 is formed of a material (a metal such as Al, or a laminated film of metals of Mo, Al, Mo, and the like) which has a resistance value lower than that of the first electrode 120. A connection member supplying a voltage to the first light-emitting-side terminal 150 is connected to the second layer 154. Meanwhile, the second layer 154 has light transmittance lower than that of the first electrode 120. Meanwhile, the first light-emitting-side terminal 150 may be constituted by only the first layer 152, or at least a portion of the terminal may be constituted by only the second layer 154.

In addition, the second light-emitting-side terminal 160 is configured such that a second layer 164 is laminated on a first layer 162. The first layer 162 is formed of the same material as that of the first conductive film 121, or is formed of a composition containing the same material and another material. However, the first layer 162 is separated from the first electrode 120. The second layer 164 is formed of the same material as that of the second layer 154. Meanwhile, the second light-emitting-side terminal 160 may be constituted by only the first layer 162, or at least a portion of the terminal may be constituted by only the second layer 164.

A conductive member is connected to the first light-emitting-side terminal 150 and the second light-emitting-side terminal 160. Both the first layer 152 and the second layer 154 of the first light-emitting-side terminal 150 extend along an end of at least one of the light emitting elements 102. For this reason, the length of the first light-emitting-side terminal 150 is increased, and thus restriction on the arrangement of the conductive member for supplying power to the light emitting device 100 is reduced. Therefore, the conductive member is easily attached to the first light-emitting-side terminal 150. Similarly, both the first layer 162 and the second layer 164 of the second light-emitting-side terminal 160 extend along an end of at least one light emitting element 102. For this reason, the length of the second light-emitting-side terminal 160 is increased, and thus restriction on the arrangement of the conductive member for supplying power to the light emitting device 100 is reduced. Therefore, the conductive member is easily attached to the second light-emitting-side terminal 160.

In addition, since the second layer 154 is provided in the first light-emitting-side terminal 150 and the second layer 164 is provided in the second light-emitting-side terminal 160, it is possible to reduce resistance values of the first light-emitting-side terminal 150 and the second light-emitting-side terminal 160.

Meanwhile, both the width (width in the horizontal direction in FIG. 1) of the first light-emitting-side terminal 150 and the width (width in the vertical direction in FIG. 1) of the second light-emitting-side terminal 160 are preferably equal to or greater than 50% of the width of the light emitting portion 104.

In addition, it is preferable that a portion of the above-mentioned conductive member which is connected to the first light-emitting-side terminal 150 (or the second light-emitting-side terminal 160) overlaps the center of the light emitting portion 104. In this manner, a voltage distribution can be further prevented from being generated in an electrode of the light emitting device 100, and thus it is possible to further suppress the generation of a luminance distribution inside the light emitting device 100.

An auxiliary electrode 124 (third conductive film, that is, an example of a conductive layer) is in contact with the first electrode 120. In the example illustrated in the drawing, the auxiliary electrode 124 is provided on a surface of the first electrode 120 which is located at a side opposite to the substrate 110. The auxiliary electrode 124 is provided along each of the plurality of light emitting elements 102, and is located in the vicinity of the opening 122. Viewed from another angle, the auxiliary electrode 124 is located between the light emitting elements 102 that are adjacent to each other. For example, the auxiliary electrode 124 is adjacent to the opening 122. A distance from the edge of the auxiliary electrode 124 on the opening 122 side to the edge of the opening 122 on the auxiliary electrode 124 side is, for example, equal to or greater than 700 um and equal to or less than 2000 um. The auxiliary electrode 124 is formed of a material (metal such as Al) which has a resistance value lower than that of the first electrode 120. It is possible to suppress the occurrence of a voltage drop in the plane of the first electrode 120 by the auxiliary electrode 124 being formed. Thereby, it is possible to suppress the generation of a luminance distribution in the light emitting device 100.

Meanwhile, in the example illustrated in the drawing, the auxiliary electrode 124 extends between two first light-emitting-side terminals 150, but is directly connected to neither of the second layers 154 of the two first light-emitting-side terminals 150. However, the auxiliary electrode 124 may be directly connected to either of the second layers 154.

As illustrated in FIG. 2, the insulating layer 170 is formed on a region of the first conductive film 121 which is not covered with the second layer 154. The insulating layer 170 is formed of a photosensitive resin such as polyimide or an inorganic material such as silicon oxide. The insulating layer 170 is provided with a plurality of openings 172. The openings 172 extend in parallel with the openings 122 and auxiliary electrodes 124. However, the opening 172 does not overlap the auxiliary electrode 124 and the opening 122 of the first electrode 120. For this reason, the auxiliary electrode 124 is covered with the insulating layer 170, and a portion of the opening 122 which is located inside the light emitting portion 104 is also covered with the insulating layer 170. In addition, the organic layer 130 mentioned above is formed inside at least the opening 172. A voltage or a current is applied between the first electrode 120 and the second electrode 140, and thus the organic layer 130 located inside the opening 172 emits light. In other words, the light emitting element 102 is formed inside each of the openings 172.

As illustrated in FIG. 2, the first conductive film 121 includes deposition portions in which the organic layer 130 is formed and non-deposition portions in which the organic layer 130 is not formed. The non-deposition portions constitute a portion of a high-resistance region 106 to be described later. A portion of the non-deposition portion serves as an exposed region 126 which is not covered with the insulating layer 170. The opening 122 mentioned above is formed in one or both of the deposition portion and the non-deposition portion. In the example illustrated in FIGS. 1 to 4, the opening 122 is formed in both the deposition portion and the non-deposition portion. In addition, the first layer 152 of the first light-emitting-side terminal 150 is provided in the non-deposition portion.

In addition, as illustrated in FIG. 4, the plurality of light emitting elements 102 are sealed by the sealing member 180. The sealing member 180 has a shape in which the entire circumference of an edge portion 182 of metallic foil or a metal plate (for example, Al foil or an Al plate) having the same polygonal shape as the substrate 110 is pressed down. The edge portion 182 is fixed to the substrate 110 using a bonding material, an adhesive material, or the like.

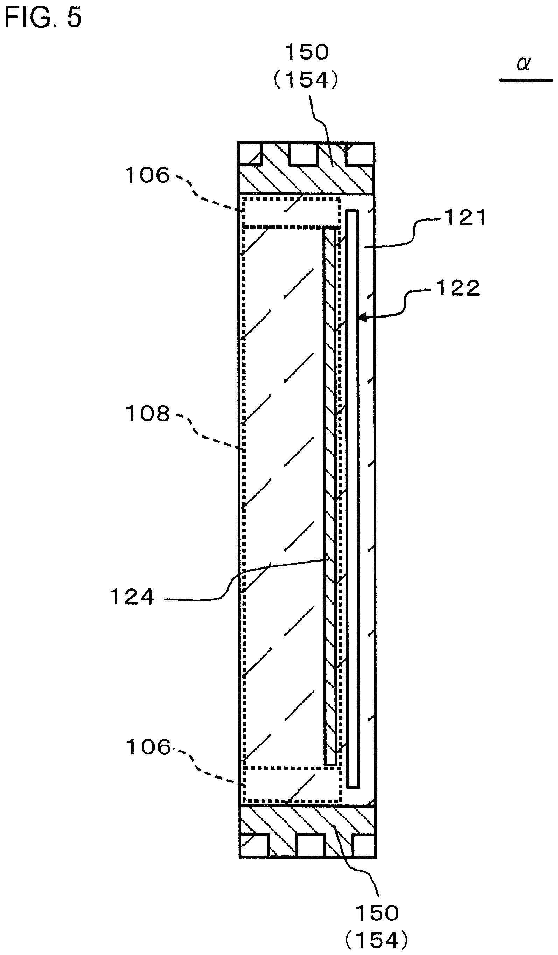

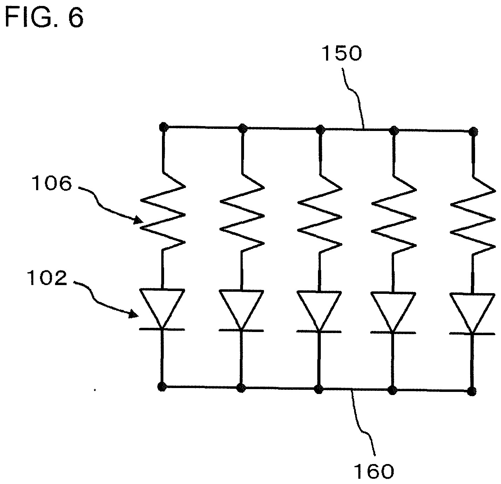

FIG. 5 is an enlarged view of a region surrounded by a dotted line α in FIG. 1. FIG. 6 is an equivalent circuit diagram of the light emitting device 100. As described above, the auxiliary electrode 124 is not directly connected to the second layer 154 of the first light-emitting-side terminal 150. For this reason, a region of the first conductive film 121 in which the auxiliary electrode 124 is not formed serves as the high-resistance region 106, and the remaining region of the first conductive film 121 serves as a low-resistance region 108. A resistance value per unit length of the high-resistance region 106 is larger than a resistance value per unit length of the low-resistance region 108. Preferably, the resistance value of the high-resistance region 106 is larger than the resistance value of the low-resistance region 108.

Meanwhile, the high-resistance region 106 may be configured such that resistance is generated between the first light-emitting-side terminal 150 and the light emitting portion 104, and may have a high resistance value or a low resistance value. For example, the high-resistance region 106 may be formed by narrowing or thinning a region of the first conductive film 121 which serves as the high-resistance region 106. In addition, a region of the first conductive film 121 in which the high-resistance region 106 is disposed may be removed, and a film having resistance higher than that of the first conductive film 121 or a chip capacitor may be disposed in a portion in which the region is removed. However, it is preferable that the high-resistance region has a high resistance value in that the high-resistance region serves as a region of a so-called current-limiting resistor preventing a voltage or a current, supplied to the light emitting portion 104 from the first light-emitting-side terminal 150, from converging on one light emitting element 102 during the supply of the voltage or the current. Although the plurality of high-resistance regions 106 are provided in the light emitting device 100, a resistance value of at least one of the plurality of high-resistance regions 106 may be different from resistance values of the other high-resistance regions 106.

As illustrated in FIG. 6, the high-resistance region 106 functions as a resistor element (protective resistor element) which is located between the first light-emitting-side terminal 150 which is an anode terminal and the light emitting element 102. Even when the first electrode 120 and the second electrode 140 short-circuit in any emitting element 102, it is possible to suppress the deterioration of the light emitting device 100 due to the convergence of a current on the light emitting element 102, by the resistor element being provided. In addition, a protective resistor element does not need to be provided and connected to the first electrode 120 by the high-resistance region 106 being provided. Therefore, it is possible to reduce the manufacturing cost of the light emitting device 100. Meanwhile, the length of the high-resistance region 106, that is, the length of a portion of the first electrode 120 which does not include the auxiliary electrode 124, is equal to or greater than 1% and equal to or less than 50% of the length (length in the vertical direction in FIG. 2) of the light emitting element 102. The length of the light emitting element 102 is preferably equal to or greater than 3% and equal to or less than 30% in that the area of the light emitting portion 104 can be increased, and is further preferably equal to or less than 5% and equal to or less than 100.

Meanwhile, in other words, in the light emitting device 10, the plurality of light emitting elements 102, the first light-emitting-side terminal 150, the second light-emitting-side terminal 160, and the resistor element are provided in the substrate 110.

In the example illustrated in FIG. 5, the area of the high-resistance region 106 is smaller than the area of the low-resistance region 108. For this reason, it is possible to prevent the high-resistance region 106 from overlapping the light emitting element 102. Meanwhile, when the high-resistance region 106 overlaps the light emitting element 102, there is the possibility of a luminance distribution being generated in the light emitting element 102.

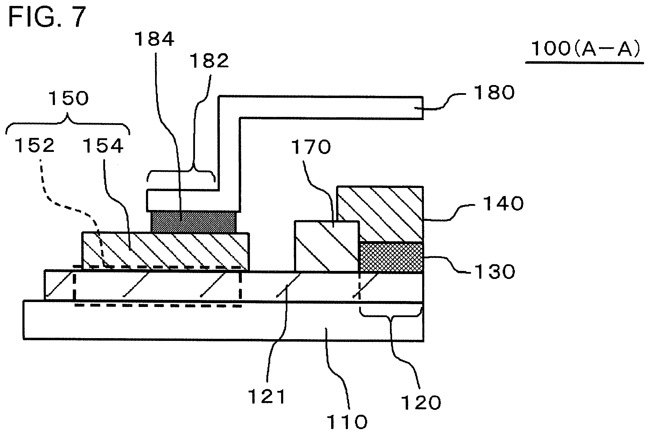

FIG. 7 is a cross-sectional view take along line A-A in FIG. 1. As described above, the first light-emitting-side terminal 150 is configured such that the second layer 154 is laminated on an end (first layer 152) of the first electrode 120. In addition, the organic layer 130 is sealed by the sealing member 180. A desiccant may be disposed inside the sealing member 180. An edge portion 182 of the sealing member 180 is fixed to a layer (second layer 154 in a A-A cross-section) which is formed on the substrate 110 through an insulating adhesive layer 184. However, a portion of the second layer 154 which is close to the edge of the substrate 110 is exposed from the edge portion 182. The above-mentioned conductive member is connected to a portion of the second layer 154 which is exposed from the edge portion 182.

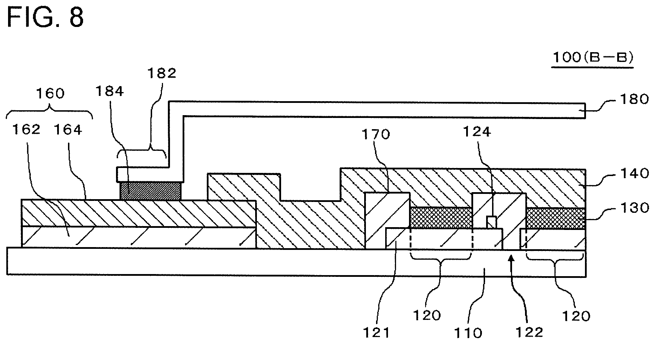

FIG. 8 is a cross-sectional view taken along line a B-B in FIG. 1. As described above, the second light-emitting-side terminal 160 is configured such that the second layer 164 (light shielding layer) is laminated on the first layer 162. The edge portion 182 of the sealing member 180 is fixed to a portion of the second light-emitting-side terminal 160 through the insulating adhesive layer 184. The above-mentioned conductive member is connected to a portion of the second light-emitting-side terminal 160 which is exposed from the edge portion 182.

### First Modification Example

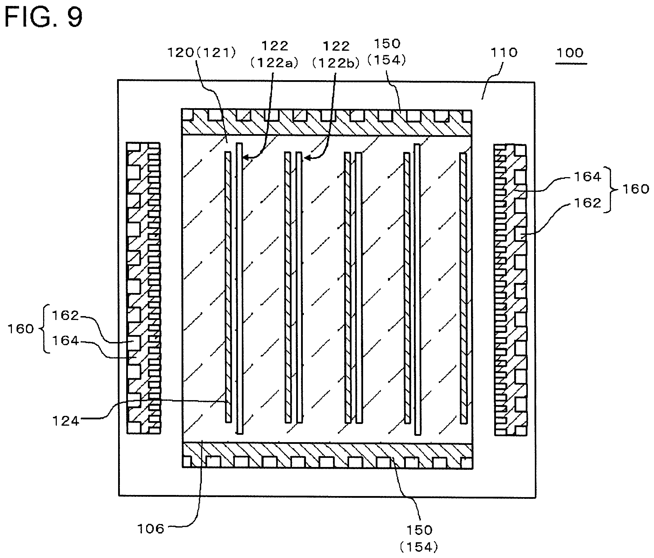

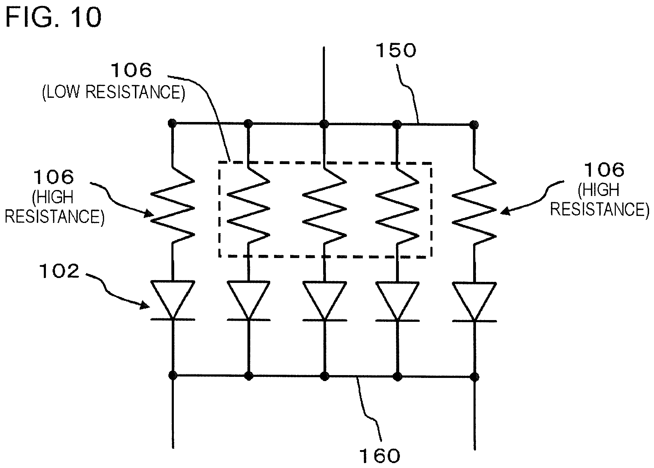

FIG. 9 is a plan view of a light emitting device 100 according to a first modification example, and corresponds to FIG. 1. FIG. 10 is an equivalent circuit diagram of the light emitting device 100 illustrated in FIG. 9, and corresponds to FIG. 6. In the example illustrated in the drawing, openings 122 include relatively long openings 122a and openings 122b that are shorter than the openings 122a. In other words, at least two of the openings 122 have lengths different from each other. The area of a first conductive film 121 in a high-resistance region 106 (see FIG. 5) located next to the opening 122a is smaller than the area of the first conductive film 121 in the high-resistance region 106 located next to the opening 122b, and thus a resistance value is increased. In other words, the high-resistance region 106 of at least one of a plurality of light emitting elements 102 has a resistance value different from those of the high-resistance regions 106 of the other light emitting elements 102. For this reason, the openings 122a are provided at appropriate positions, and thus it is possible to suppress the generation of a luminance distribution in a light emitting portion 104.

For example, in the example illustrated in the drawing, the substrate 110 has a rectangular shape, the first light-emitting-side terminals 150 are provided at two sides of the substrate 110 which face each other, and the second light-emitting-side terminals 160 are provided at the remaining two sides. In this case, the light emitting element 102 located closest to the second light-emitting-side terminal 160 has luminance higher than those of the other light emitting elements 102. Consequently, the opening 122 located on the end side of the substrate 110 is assumed to be the opening 122a and is set to be shorter than the opening 122 located on the center side of the substrate 110. As an example, when the opening 122 located closest to the second light-emitting-side terminal 160 is assumed to be the opening 122a, it is possible to suppress the generation of a luminance distribution in the light emitting portion 104.

### Second Modification example

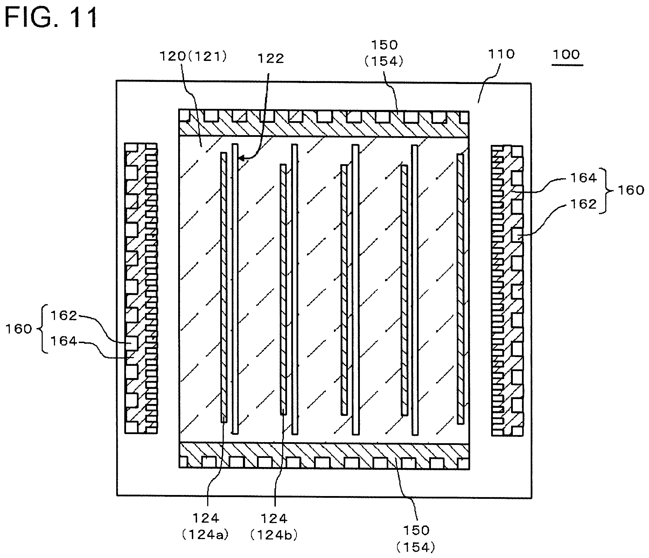

FIG. 11 is a plan view of a light emitting device 100 according to a second modification example, and corresponds to FIG. 9. The light emitting device 100 illustrated in the drawing is configured in the same manner as the light emitting device 100 illustrated in FIG. 9 except that at least one auxiliary electrode 124 has a length different from those of the other auxiliary electrodes 124 to make up for openings 122 having the same length. Specifically, in a light emitting element 102 in which a high-resistance region 106 is desired to be increased in resistance, the auxiliary electrode 124 is set to be shorter than the other auxiliary electrodes 124. In other words, at least two auxiliary electrodes 124 have different lengths. In this manner, it is possible to suppress the generation of a luminance distribution in the light emitting portion 104. For example, in the example illustrated in FIG. 11, an auxiliary electrode 124a located on the end side of a substrate 110 is longer than an auxiliary electrode 124b located on the center side of the substrate 110.

### Third Modification Example

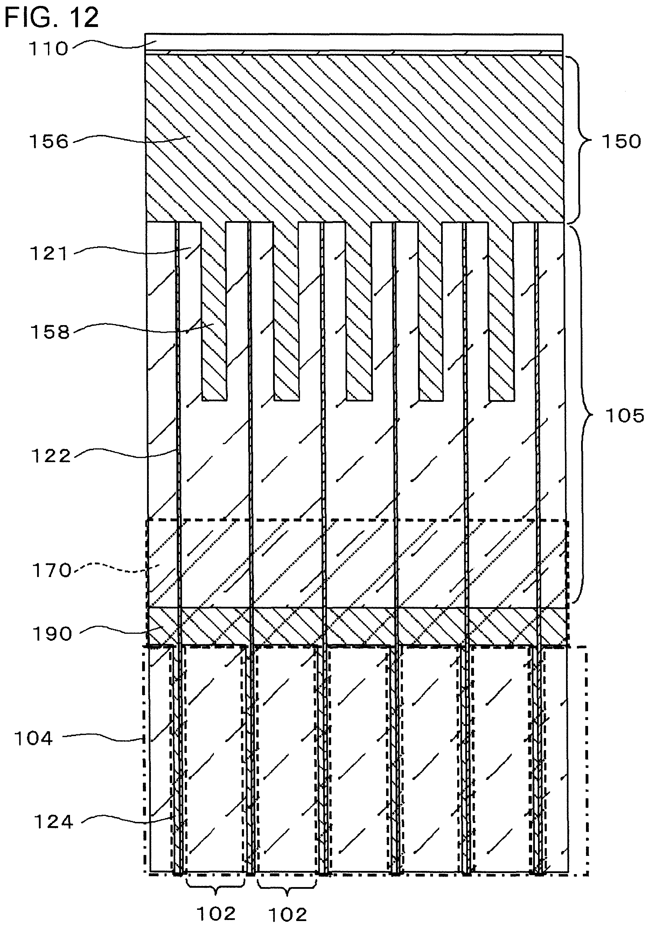

FIG. 12 is a plan view illustrating main portions of a light emitting device 100 according to a third modification example. This drawing is an enlarged diagram of a portion of the light emitting device 100 in the vicinity of a first light-emitting-side terminal 150. In the drawing, an organic layer 130, a second electrode 140, and a sealing member 180 are not shown.

In FIG. 12 illustrating the light emitting device 100, the first light-emitting-side terminal 150, a resistance region 105, and a light emitting portion 104 are shown from the upper side toward the lower side. Here, the resistance region 105 is only required to have resistance generated between the first light-emitting-side terminal 150 and the light emitting portion 104, and may have a high resistance value or a low resistance value. However, it is preferable that the resistance region 105 has a (high) resistance value equal to or greater than a fixed value in that the resistance region serves as a region of a so-called current-limiting resistor preventing a voltage or a current, supplied to the light emitting portion 104 from the first light-emitting-side terminal 150, from converging on one light emitting element 102 (for example, an organic EL element) during the supply of the voltage or the current.

The first light-emitting-side terminal 150 has a relatively wide region. The first light-emitting-side terminal 150 has a laminated structure in which a fourth conductive film 156 formed of a metal having a resistance value smaller than that of a first conductive film 121 is deposited on the first conductive film 121 constituting a first electrode 120. Here, the fourth conductive film 156 may be constituted by a film formed of a metal material such as Al, or a laminated film, formed of Mo which is hardly oxidized, with the above-mentioned metal material interposed therein. For example, the fourth conductive film 156 is a film in which a Mo alloy, an Al alloy, and a Mo alloy are laminated in this order.

The resistance region 105 is a portion of the first conductive film 121. The first conductive film 121 includes a plurality of openings 122. In addition, the fourth conductive film 156 mentioned above may be laminated on at least a portion of the resistance region 105 in order to adjust the resistance value of the resistance region. In the example illustrated in the drawing, the fourth conductive film 156 located at the first light-emitting-side terminal 150 protrudes to the resistance region side, thereby forming a projection portion 158. The projection portion 158 extends toward the light emitting portion 104 (light emitting elements 102). The length of the projection portion 158 may be substantially the same as or smaller than the length of the resistance region 105, and can be appropriately set between 0% and 1000 of the length of the resistance region 105. In the case illustrated in the drawing, the length of the projection portion 158 is approximately 30% to 50% of the length of the resistance region 105.

In each of the light emitting elements 102 of the light emitting portion 104, a fifth conductive film 190 is formed in the outer peripheral portion (end) of the light emitting element. The fifth conductive film 190 extends along one side of the first light-emitting-side terminal 150 or a substrate 110, and then is bent and extended along the openings 122 of the first conductive film 121. A portion along the opening 122 is set to be an auxiliary electrode 124. For example, the fifth conductive film 190 has the same layered structure as the fourth conductive film 156. The fifth conductive film 190 is not formed on the opening 122. That is, the fifth conductive film 190 is provided with respect to each of the light emitting elements 102. The fifth conductive film 190 formed along one side of the first light-emitting-side terminal 150 or the substrate 110 is covered with an insulating layer 170, and the insulating layer 170 is also annularly formed so as to surround the light emitting portion 104. In addition, the fifth conductive film 190 (for example, the auxiliary electrode 124) extending along the openings 122 of the first conductive film 121 and the openings 122 of the first conductive film 121 are covered with the insulating layer 170. In other words, the insulating layer 170 includes an annular portion and a portion (linear portion) which is located on the inner side of the annular portion along the opening 122.

Meanwhile, a region (including a region in which the fifth conductive film 190 is formed) of the first conductive film 121 which is covered with the annular portion of the insulating layer 170 also has resistance, and thus may be used as the resistance region 105. Thereby, it is possible to increase the adjustment width of a resistance value of the resistance region, and to reduce the area of a non-light emitting portion by making a portion of the resistance region 105 overlap a portion of the light emitting portion 104.

### Fourth Modification Example

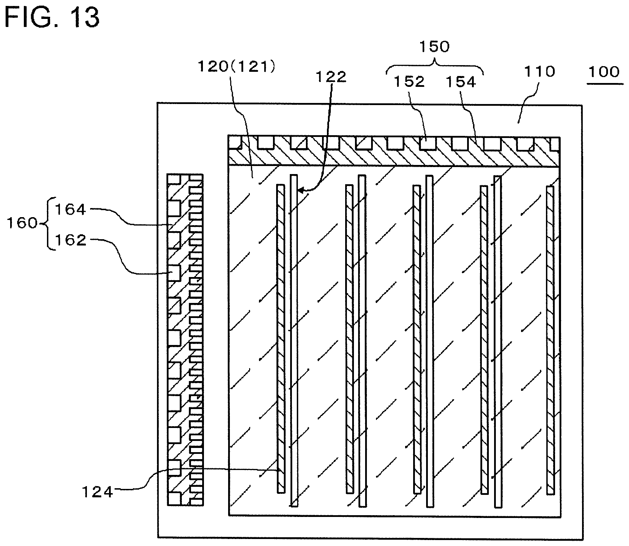

FIG. 13 is a plan view illustrating a configuration of a light emitting device 100 according to a fourth modification example, and corresponds to FIG. 1 according to the embodiment. The light emitting device 100 according to the present modification example is configured in the same manner as the light emitting device 100 according to the embodiment except that the light emitting device according to the present modification example includes one first light-emitting-side terminal 150 and one second light-emitting-side terminal 160.

Also in the present modification example, the high-resistance region 106 illustrated in FIG. 5 is provided, and thus it is possible to prevent a voltage or a current supplied to a light emitting portion 104 from converging on one light emitting element 102.

### Fifth Modification Example

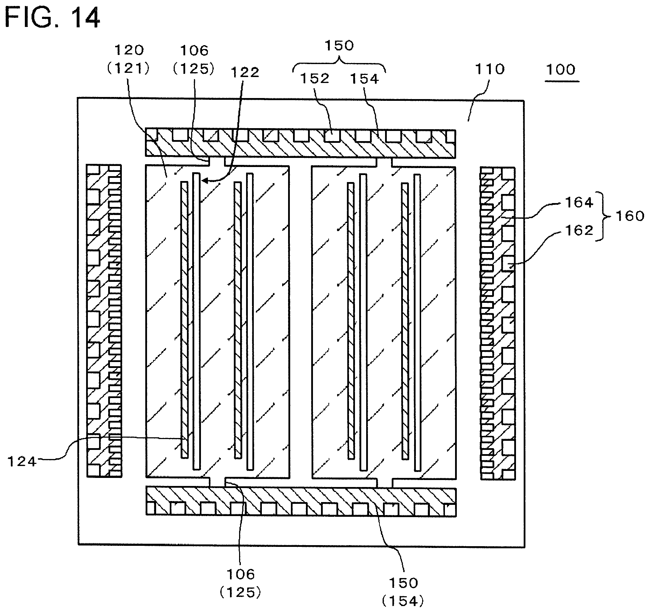

FIG. 14 is a plan view illustrating a configuration of a light emitting device 100 according to a fifth modification example, and corresponds to FIG. 1 according to the embodiment. The light emitting device 100 according to the present modification example is configured in the same manner as the light emitting device 100 according to the embodiment except for a planar shape of a first conductive film 121.

In the present modification example, a region of the first conductive film 121 which functions as a first electrode 120 is divided into a plurality of portions with a plurality of light emitting elements 102 as one unit. The plurality of first electrodes 120 belonging to one unit are connected to a first light-emitting-side terminal 150 through a common high-resistance region 106. In the present modification example, the high-resistance region 106 is constituted by a narrow region 125 formed by thinning a portion of the first conductive film 121. The narrow region 125 is given a desired resistance value by adjusting the width and length of the narrow region 125.

Also in the present modification example, the high-resistance region 106 illustrated in FIG. 5 is provided, and thus it is possible to prevent a voltage or a current supplied to a light emitting portion 104 from converging on one light emitting element 102.

### Sixth Modification Example

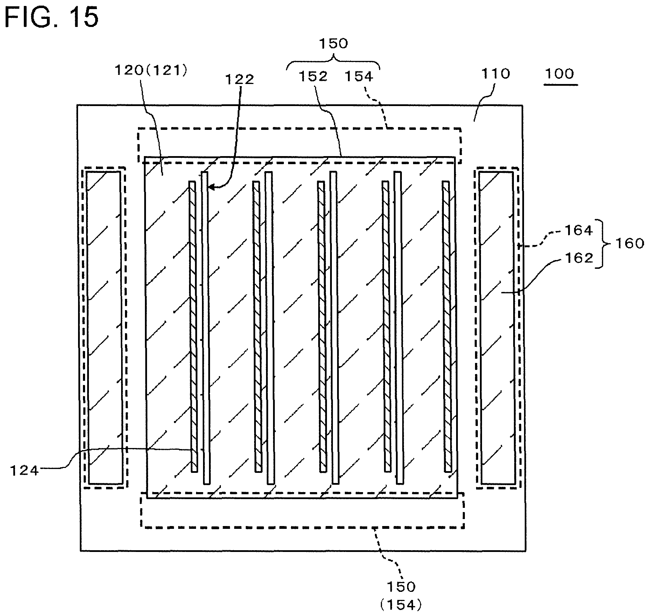

FIG. 15 is a plan view illustrating a configuration of a light emitting device 100 according to a sixth modification example, and corresponds to FIG. 1 according to the embodiment. The light emitting device 100 according to the present modification example is configured in the same manner as the light emitting device 100 according to the embodiment except for a configuration of a first light-emitting-side terminal 150.

In the present modification example, a first layer 152 of the first light-emitting-side terminal 150 is formed in only a partial region of the first light-emitting-side terminal 150. In a portion of the first light-emitting-side terminal 150 in which the first layer 152 is not formed, a second layer 154 is in contact with a substrate 110. In the example illustrated in the drawing, the first layer 152 is formed in only a region of the first light-emitting-side terminal 150 on a light emitting portion 104 side, but the planar shape of the first layer 152 is not limited to the example illustrated in the drawing.

Also in the present modification example, the high-resistance region 106 illustrated in FIG. 5 is provided, and thus it is possible to prevent a voltage or a current supplied to the light emitting portion 104 from converging on one light emitting element 102.

### Seventh Modification Example

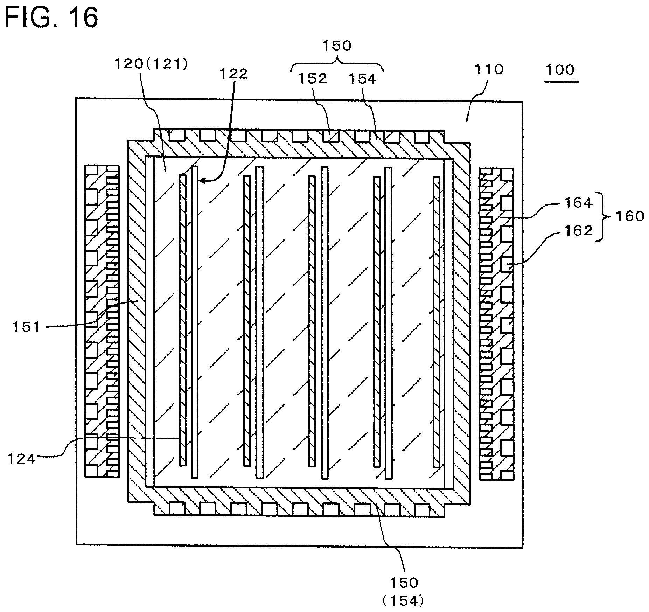

FIG. 16 is a plan view illustrating a configuration of a light emitting device 100 according to a seventh modification example, and corresponds to FIG. 1 according to the embodiment. The light emitting device 100 according to the present modification example is configured in the same manner as the light emitting device 100 according to the embodiment except that the light emitting device according to the present modification example includes an interconnect 151.

The interconnect 151 extends between a first light-emitting-side terminal 150 and a light emitting portion 104, and connects two first light-emitting-side terminals 150. The interconnect 151 includes a second layer 154, similar to the first light-emitting-side terminal 150. Meanwhile, also in the first light-emitting-side terminal 150, a first layer 152 may be formed under the second layer 154. The width of the interconnect 151 may be larger than the width of an auxiliary electrode 124. It is possible to suppress the generation of a difference in voltage between the two first light-emitting-side terminals 150 by the interconnect 151 being provided.

Also in the present modification example, the high-resistance region 106 illustrated in FIG. 5 is provided, and thus it is possible to prevent a voltage or a current supplied to the light emitting portion 104 from converging on one light emitting element 102.

### Eighth Modification Example

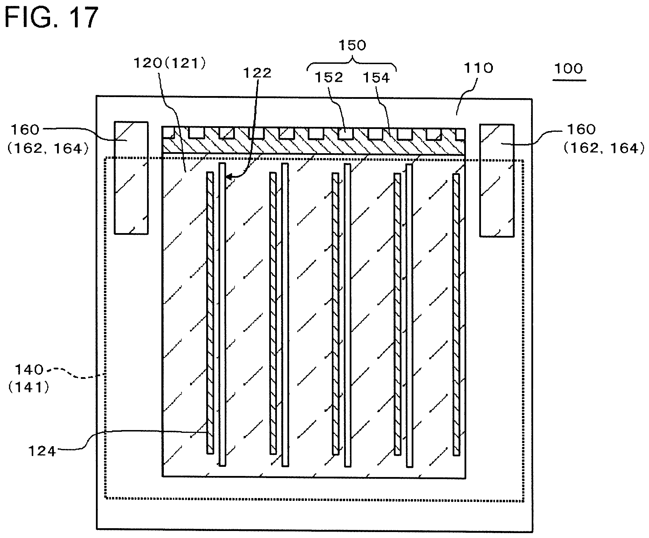

FIG. 17 illustrates a configuration of a light emitting device 100 according to an eighth modification example, and corresponds to FIG. 1 according to the embodiment. The light emitting device 100 according to the present modification example is configured in the same manner as the light emitting device 100 according to the embodiment except for the following respects.

First, a first light-emitting-side terminal 150 and a second light-emitting-side terminal 160 are provided along the same side of a substrate 110. Specifically, the second light-emitting-side terminals 160 are provided at both sides of the first light-emitting-side terminal 150.

A portion of a second conductive film 141 overlaps the second light-emitting-side terminal 160, and the second conductive film is connected to the second light-emitting-side terminal 160 through the overlapping portion. Specifically, an insulating layer 170 (see FIG. 2) is not formed in the portion in which the second conductive film 141 and the second light-emitting-side terminal 160 overlap each other. The second conductive film 141 is in contact with the second light-emitting-side terminal 160 in the portion.

Also in the present modification example, the high-resistance region 106 illustrated in FIG. 5 is provided, and thus it is possible to prevent a voltage or a current supplied to the light emitting portion 104 from converging on one light emitting element 102.

### Ninth Modification Example

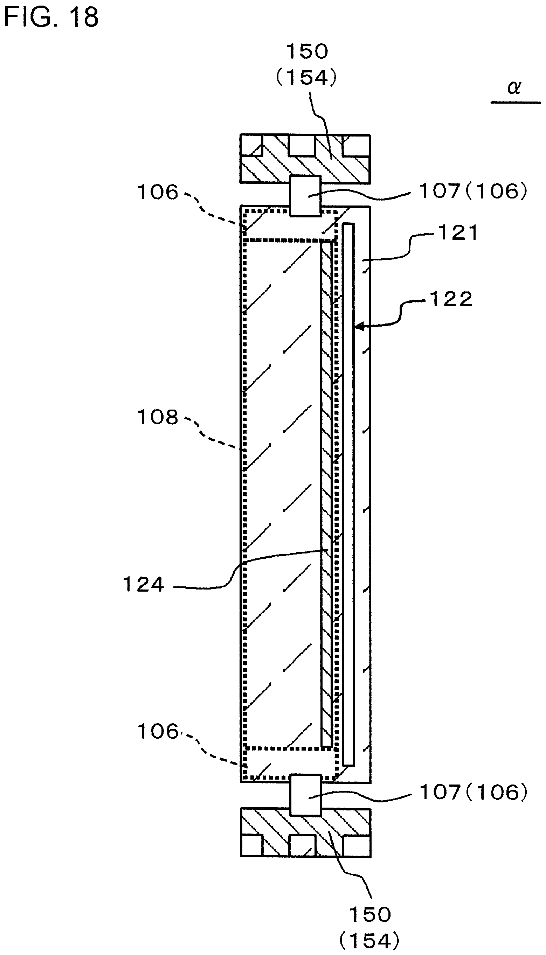

FIG. 18 is a plan view illustrating a configuration of a light emitting device 100 according to a ninth modification example, and corresponds to FIG. 5 according to the embodiment. The light emitting device 100 according to the present modification example is configured in the same manner as the light emitting device 100 according to the embodiment except that a chip resistor 107 is provided as a high-resistance region 106.

In detail, a first conductive film 121 is divided between a first layer 152 and a first electrode 120. Regions obtained by the division are electrically connected to each other through the chip resistor 107. A resistance value of the chip resistor 107 is appropriately selected. A known chip resistor can be used as the chip resistor 107, and chip resistors (also referred to as resistors) such as a square shape, a cylindrical shape, a metal plate type, a resin mold type, and a ceramic case enclosed type can be used.

According to the present modification example, the chip resistor 107 is provided as the high-resistance region 106, and thus it is possible to prevent a voltage or a current supplied to the light emitting portion 104 from converging on one light emitting element 102. In addition, it is possible to widen a selection range of resistance values of the high-resistance region 106.

### Tenth Modification Example

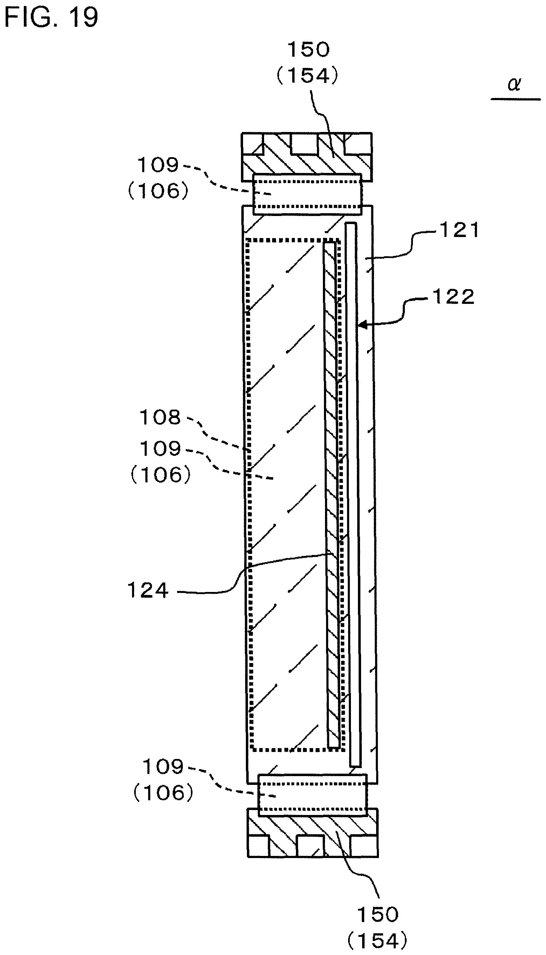

FIG. 19 is a plan view illustrating a configuration of a light emitting device 100 according to a tenth modification example, and corresponds to FIG. 18 according to the ninth modification example. The light emitting device 100 according to the present modification example is configured in the same manner as the light emitting device 100 according to the ninth modification example except that a high resistance film 109 is formed instead of a chip resistor 107.

The high resistance film 109 is formed of a material having a sheet resistance higher than that of a first conductive film 121, for example, polysilicon having impurities introduced thereinto. Meanwhile, the high resistance film 109 may be formed of any of other materials. For example, the high resistance film 109 is formed by a vapor phase growth method such as a sputtering method or a CVD method, or a coating method such as an ink jet method or a printing method after forming the first conductive film and before forming the insulating layer 170.

According to the present modification example, the high resistance film 109 is provided as a high-resistance region 106, and thus it is possible to prevent a voltage or a current supplied to the light emitting portion 104 from converging on one light emitting element 102. In addition, it is possible to widen a selection range of resistance values of the high-resistance region 106.

### Eleventh Modification Example

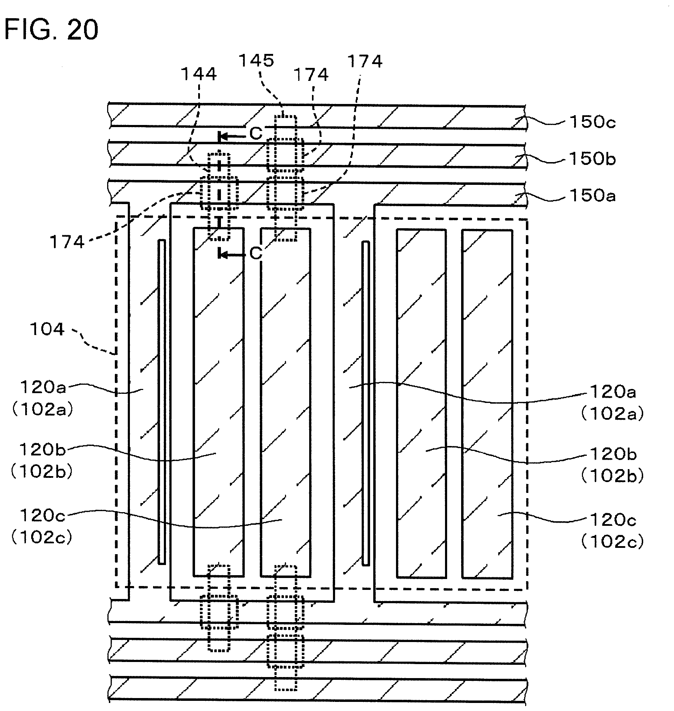

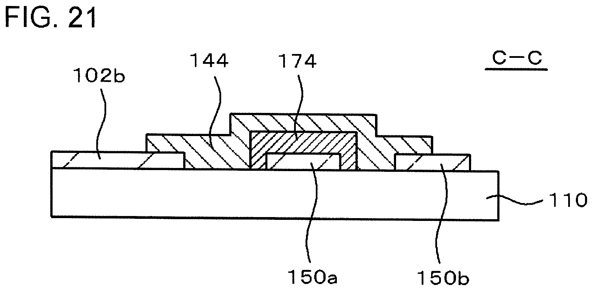

FIG. 20 is a plan view illustrating a configuration of a light emitting device 100 according to an eleventh modification example, and corresponds to FIG. 19 according to the tenth modification example. FIG. 21 is a cross-sectional view taken along line C-C in FIG. 20. The light emitting device 100 according to the present modification example is configured in the same manner as the light emitting device 100 according to the tenth modification example except for the following respects. Meanwhile, in the drawing, a plurality of light emitting elements 102 are shown for convenience of description.

First, a light emitting portion 104 includes a plurality of types of light emitting elements 102 (light emitting elements 102a, 102b, and 102c). The plurality of types of light emitting elements 102a, 102b, and 102c emit lights of different colors (for example, red, green, and blue), and are repeatedly disposed in a direction in which a first light-emitting-side terminal 150 extends. The first light-emitting-side terminal 150 is provided with respect to each of the plurality of light emitting elements 102a,102b,102c (first light-emitting-side terminals 150a, 150b, and 150c).

In detail, the first electrode 120a of the light emitting element 102a, the first electrode 120b of the light emitting element 102b, and the first electrode 120c of the light emitting element 102c are separated from each other. The first light-emitting-side terminals 150a, 150b, and 150c are disposed in this order in a direction moving away from the light emitting portion 104 in this order. The first electrode 120a is connected to the first light-emitting-side terminal 150a by a first conductive film 121. On the other hand, the first electrode 120b is connected to the first light-emitting-side terminal 150b through an interconnect 144, and the first electrode 120c is also connected to the first light-emitting-side terminal 150c through an interconnect 145.

As illustrated in FIG. 20, the interconnect 144 extends in a direction intersecting the first light-emitting-side terminal 150a, and the interconnect 145 extends in a direction intersecting the first light-emitting-side terminal 150a and the first light-emitting-side terminal 150b. Here, an insulating layer 174 is provided between the interconnect 144 and the first light-emitting-side terminal 150a, between the interconnect 145 and the first light-emitting-side terminal 150a, and between the interconnect 145 and the first light-emitting-side terminal 150b. Meanwhile, for example, the insulating layer 174 is formed in the same process as the insulating layer 170. In addition, for example, the interconnects 144 and 145 are formed in the same process as a second conductive film 141.

According to the present modification example, the light emitting portion 104 includes a plurality of types of light emitting elements 102a, 102b, and 102c. The first electrode 120a of the light emitting element 102a is connected to the first light-emitting-side terminal 150a, the first electrode 120b of the light emitting element 102b is connected to the first light-emitting-side terminal 150b, and the first electrode 120c of the light emitting element 102c is connected to the first light-emitting-side terminal 150c. All of the first light-emitting-side terminals 150a, 150b, and 150c are formed on a substrate 110, but may be electrically separated from each other on the substrate 110. For this reason, light emission intensities of the respective light emitting elements 102a, 102b, and 102c may be independently set. Therefore, the light emitting device 100 is configured to be capable of being toned.

In addition, for example, a high-resistance region 106 having a structure described in the embodiment is formed between the first electrode 120a and the first light-emitting-side terminal 150a. In addition, a high-resistance region 106 is formed between the first electrode 120b and the first light-emitting-side terminal 150b by narrowing the width of the interconnect 144. Similarly, a high-resistance region 106 is also formed between the first electrode 120c and the first light-emitting-side terminal 150c by narrowing the width of the interconnect 145. Therefore, also in the present modification example, it is possible to prevent a voltage or a current supplied to the light emitting portion 104 from converging on one light emitting element 102.

Meanwhile, an auxiliary electrode 124 may be provided for each of the light emitting elements 102a, 102b, and 102c along the light emitting elements 102a, 102b, and 102c. An opening 122 may be provided for each light emitting element 102a, each set of light emitting elements 102a and102b, or each set of light emitting elements 102a, 102b, and 102c.

The application is based on International Application No. PCT/JP2013/082107 filed on November 28, 2013.

## Claims

1. A light emitting device comprising:
a substrate (110) comprising a light emitting portion (104);
a plurality of organic EL elements (102) on the substrate (110) in the light emitting portion (104), each organic EL element (102) comprising a first electrode (120), a second electrode (140) and an organic EL layer (130) sandwiched between the first and second electrodes (140),
wherein the plurality of first electrodes (120) are formed from a first conductive film (121) formed continuously on the substrate (110) in the light emitting portion (104), said conductive film (121) comprising a plurality of elongated openings (122) extending between the organic light emitting layers and dividing the conductive film into said plurality of first electrodes (120), the plurality of first electrodes (120) being connected to each other and functioning as a common electrode;
wherein the second electrodes (140) are formed as an electrode common to the plurality of light emitting elements (102),
a first connection terminal (150) that is provided at a position of the substrate (110) which does not overlap the plurality of organic EL elements (102), the first connection terminal (150) being connected to the first electrodes (120),
a second connection terminal (160) that is provided at a position of the substrate (110) which does not overlap the plurality of organic EL elements (102); the second connection terminal (160) being connected to the second electrodes (140), wherein the first connection terminal (150) extends in a first direction and the second connection terminal (160) extends in a second direction which intersects the first direction,
wherein the first electrodes (120) are connected to the first connection terminal (150) through a resistor element (106) that is provided on the substrate (110),
a plurality of auxiliary electrodes (124) provided on a surface of the first electrode (120) which is located at a side opposite to the substrate (110), the auxiliary electrodes (124) being provided along each of the plurality of light emitting elements, and are located in the vicinity of the opening (122),
wherein a region of the first conductive film (121) between the organic EL elements (102) and the first connection terminal (150) in which the auxiliary electrode (124) is not formed serves as a high-resistance region, the high-resistance region functioning as said resistor element (106) .

2. The light emitting device according to claim 1,
wherein the first conductive film (121) includes a deposition portion in which the organic layer (130) is formed and a non-deposition portion in which the organic layer (130) is not formed.

3. The light emitting device according to claim 2,
wherein the opening (122) is formed in one or both of the deposition portion and the non-deposition portion.

4. The light emitting device according to claim 3,
wherein the auxiliary electrodes (124) are formed in the deposition portion of the organic layer (130).

## Patentansprüche

1. Lichtemittierende Vorrichtung, aufweisend:
ein Substrat (110), das einen lichtemittierenden Abschnitt (104) aufweist;
eine Mehrzahl von organischen EL-Elementen (102) auf dem Substrat (110) in dem lichtemittierenden Abschnitt (104), wobei jedes organische EL-Element (102) eine erste Elektrode (120), eine zweite Elektrode (140) und eine organische EL-Schicht (130), die zwischen der ersten und der zweiten Elektrode (140) sandwichartig angeordnet ist, aufweist,
wobei die Mehrzahl von ersten Elektroden (120) durch einen ersten leitenden Film (121) gebildet sind, der kontinuierlich auf dem Substrat (110) in dem lichtemittierenden Abschnitt (104) ausgebildet ist, wobei der leitende Film (121) eine Mehrzahl von länglichen Öffnungen (122) aufweist, die sich zwischen den organischen lichtemittierenden Schichten erstrecken und den leitenden Film in die Mehrzahl von ersten Elektroden (120) unterteilen, wobei die Mehrzahl von ersten Elektroden (120) miteinander verbunden sind und als gemeinsame Elektrode fungieren;
wobei die zweiten Elektroden (140) als gemeinsame Elektrode mit der Mehrzahl von lichtemittierenden Elementen (102) ausgebildet sind,
einen ersten Verbindungsanschluss (150), der an einer Position des Substrats (110) bereitgestellt ist, welche die Mehrzahl von organischen EL-Elementen (102) nicht überschneidet, wobei der erste Verbindungsanschluss (150) mit den ersten Elektroden (120) verbunden ist,
einen zweiten Verbindungsanschluss (160), der an einer Position des Substrats (110) bereitgestellt ist, welche die Mehrzahl von organischen EL-Elementen (102) nicht überschneidet; wobei der zweite Verbindungsanschluss (160) mit den zweiten Elektroden (140) verbunden ist, wobei sich der erste Verbindungsanschluss (150) in einer ersten Richtung erstreckt und sich der zweite Verbindungsanschluss (160) in einer zweiten Richtung erstreckt, welche die erste Richtung schneidet,
wobei die ersten Elektroden (120) durch ein Widerstandselement (106), das auf dem Substrat (110) bereitgestellt ist, mit dem ersten Verbindungsanschluss (150) verbunden sind,
eine Mehrzahl von Zusatzelektroden (124), die auf einer Fläche der ersten Elektrode (120) bereitgestellt sind, die auf einer dem Substrat (110) gegenüberliegenden Seite angeordnet ist, wobei die Zusatzelektroden (124) entlang jeder der Mehrzahl von lichtemittierenden Elementen bereitgestellt sind und in der Nähe der Öffnung (122) angeordnet sind,
wobei ein Bereich des ersten leitenden Films (121) zwischen den organischen EL-Elementen (102) und dem ersten Verbindungsanschluss (150), in dem die Zusatzelektrode (124) nicht ausgebildet ist, als Hochwiderstandsbereich dient, wobei der Hochwiderstandsbereich als das Widerstandselement (106) fungiert.

2. Lichtemittierende Vorrichtung nach Anspruch 1,
wobei der erste leitende Film (121) einen Ablagerungsabschnitt, in dem die organische Schicht (130) ausgebildet ist, und einen Nichtablagerungsabschnitt, in dem die organische Schicht (130) nicht ausgebildet ist, aufweist.

3. Lichtemittierende Vorrichtung nach Anspruch 2,
wobei die Öffnung (122) in dem Ablagerungsabschnitt und/oder in dem Nichtablagerungsabschnitt ausgebildet ist.

4. Lichtemittierende Vorrichtung nach Anspruch 3,
wobei die Zusatzelektroden (124) in dem Ablagerungsabschnitt der organischen Schicht (130) ausgebildet sind.

## Revendications

1. Dispositif électroluminescent comprenant :
un substrat (110) comprenant une partie électroluminescente (104) ;
une pluralité d'éléments électroluminescents, EL, organiques (102) sur le substrat (110) dans la partie électroluminescente (104), chaque élément EL organique (102) comprenant une première électrode (120), une seconde électrode (140) et une couche EL organique (130) prise en sandwich entre les première et seconde électrodes (140),
dans lequel la pluralité de premières électrodes (120) sont formées à partir d'un premier film conducteur (121) formé en continu sur le substrat (110) dans la partie électroluminescente (104), ledit film conducteur (121) comprenant une pluralité d'ouvertures allongées (122) s'étendant entre les couches électroluminescentes organiques et divisant le film conducteur en ladite pluralité de premières électrodes (120), la pluralité de premières électrodes (120) étant connectées les unes aux autres et fonctionnant comme une électrode commune ;
dans lequel les secondes électrodes (140) sont formées comme une électrode commune avec la pluralité d'éléments électroluminescents (102),
une première borne de connexion (150) qui est ménagée à une position du substrat (110) qui ne chevauche pas la pluralité d'éléments EL organiques (102), la première borne de connexion (150) étant connectée aux premières électrodes (120),
une seconde borne de connexion (160) qui est ménagée à une position du substrat (110) qui ne chevauche pas la pluralité d'éléments EL organiques (102) ; la seconde borne de connexion (160) étant connectée aux secondes électrodes (140), dans lequel la première borne de connexion (150) s'étend dans une première direction et la seconde borne de connexion (160) s'étend dans une seconde direction qui fait intersection avec la première direction,
dans lequel les premières électrodes (120) sont connectées à la première borne de connexion (150) par le biais d'un élément à résistance (106) qui est ménagé sur le substrat (110),
une pluralité d'électrodes auxiliaires (124) ménagées sur une surface de la première électrode (120) qui est située au niveau d'un côté opposé au substrat (110), les électrodes auxiliaires (124) étant ménagées le long de chacun de la pluralité d'éléments électroluminescents, et sont situées au voisinage de l'ouverture (122),
dans lequel une région du premier film conducteur (121) entre les éléments EL organiques (102) et la première borne de connexion (150) dans laquelle l'électrode auxiliaire (124) n'est pas formée constitue une région à résistance élevée, la région à résistance élevée fonctionnant comme ledit élément à résistance (106).

2. Dispositif électroluminescent selon la revendication 1,
dans lequel le premier film conducteur (121) inclut une partie de dépôt dans laquelle la couche organique (130) est formée et une partie de non-dépôt dans laquelle la couche organique (130) n'est pas formée.

3. Dispositif électroluminescent selon la revendication 2,
dans lequel l'ouverture (122) est formée dans l'une ou les deux parmi la partie de dépôt et la partie de non-dépôt.

4. Dispositif électroluminescent selon la revendication 3,
dans lequel les électrodes auxiliaires (124) sont formées dans la partie de dépôt de la couche organique (130).
